# EUROPEAN PATENT APPLICATION

(11) **EP 4 249 696 A1**
(43) Date of publication of application: **27.09.2023**
(21) Application number: 22163364.7
(22) Date of filing: 21.03.2022
(51) Int. Cl.: E04D 1/04, H02S 20/25, H01L 31/048

(54) **ROOF TILE, METHOD FOR PRODUCING A ROOF TILE AND A MACHINE FOR THE PRODUCTION OF A ROOF TILE**

(71) Applicant: Abece AB, 611 29 Nyköping (SE)
(72) Inventor: LINDEBERG, Erik, 611 45 Nyköping (SE)
(74) Representative: Zacco Sweden AB

(57) **Abstract**

Roof tile (100) wherein the roof tile comprises a base element (110) and further is comprised a transparent top element (120), wherein the roof tile (100) comprises a group of solar panel elements (130), wherein the solar panel elements are comprised between the top element (120) and the base element (110), under or within the top element, wherein the roof tile (100) comprises a profiled shape section which comprises solar panel elements (130), wherein the profiled shape section allows for different angles of reception of sun rays within the roof tile (100), wherein the base element (110) comprises concrete or clay. The disclosure is also related to a roof comprising a plurality of roof tiles, a method for producing a roof tile and to a machine for producing a roof tile.

## Description

### TECHNICAL FIELD

The present disclosure relates to a roof tile according to claim 1. The disclosure is also related to a roof comprising a plurality of roof tiles according to claim 10, a method for producing a roof tile according to claim 11 and to a machine for producing the roof tile according to claim 15.

### BACKGROUND ART

There is a large interest in utilizing solar energy for producing electricity by arranging solar panels onto roofs of buildings. The solar panels are typically mounted as large arrangements to an existing roof.

In recent years, different approaches where a solar panel is provided to each individual roof tile have been proposed. This offers a more aesthetic appearance of the roof as compared to large solar panel arrangements. It also provides for flexibility since the roof tiles may be effectively arranged on a roof comprising angles and corners onto which large solar panels arrangement is not appropriate. In some examples, a solar panel is attached onto the roof tile. In other examples, thin film solar cells are integrated within the roof tile.

Document US 10 454 409 B2 discloses an example of a solar roof tile.

### SUMMARY OF THE INVENTION

It is desired to provide a roof tile that protects a building from weather conditions and at the same time acts as a solar panel. There is also need for a roof tile with an integrated solar panel which provides a strength which is comparable with a conventional roof tile and which provides for an efficient installation on a building. There is also need for a roof tile which has the ability to harvest energy from the sun at a long section of the day.

An object of the present disclosure is to provide a roof tile wherein some of the problems with prior art technologies are mitigated or at least alleviated.

The disclosure proposes a roof tile wherein the roof tile comprises a base element and further is comprised a transparent top element. The roof tile comprises a group of solar panel elements, wherein the solar panel elements are comprised between the top element and the base element, under or within the top element. The roof tile comprises a profiled shape section which comprises solar panel elements. The profiled shape section allows for different angles of reception of direct and indirect sunrays within the roof tile. The base element comprises concrete or clay.

The advantages of the above roof tile is that it will provide a complete roof tile that may both give the ability to protect a building from weather conditions, in particular rain, and to produce electricity. Thus, there is no need to add further protection or a separate solar panel device to an already complete roof. The roof tile will also provide a way to harvest energy from the sun at a long section of the day. The profiled shape is clearly an advantage when the sun is not at a perfect angle to a roof on which the roof tiles are applied. The profiled shape is also clearly an advantage since more solar panel elements may be arranged per area unit as compared to on a flat section. The roof tile is also cost efficient as compared to conventional solar panels since a broken roof tile easily can be replaced, and since the roof tile comprises solar panel elements there is no need for both roof tiles and then also a separate solar panel.

The group of solar panel elements may comprise silicon, and/or the top element may comprise glass or resin, preferably the top element may comprise tempered glass, and/or the base element may comprise extruded concrete or clay.

The advantage of providing a silicone based solar panel elements is that a very high efficiency is achieved for the solar panel elements per area unit. The silicon solar panels are also reliable and will provide a good efficiency for a long time that is required when looking at long-term application of solar panel elements.

The advantage is that the material is both transparent and have good mechanical properties. The roof will be possible to maintain, for example, snow can be removed without risk of damaging the surface. In addition, even if the top surface is aged or damaged, the glass material will still maintain a good transparency.

The advantage of providing a roof tile in with a base element of concrete is a very solid and mechanically resistant. This will provide for a roof that have good properties over time. By using clay as material, the advantage compared with concrete is a less heavy roof tile.

The roof tile may comprise at least one interlocking section. The interlocking section may comprise concrete or clay, preferably extruded concrete or clay.

The advantage is that the interlocking section between the top element and the base element is mainly provided in terms of the base element. The base element is provided in a robust material and the interlocking section will have high reliability and will have good properties as regards failure. By providing an extruded base element, a homogenous and dimension stable base element is provided.

The roof tile may comprise at least one intermediate element between the top element and the base element.

The advantage of this is that the at least one intermediate element provides for a support and/or protection for the solar panel elements.

The group of solar panel elements may comprise at least two solar panel elements, preferably the group of solar panel elements may comprise 10-100, preferably 40-60 or even more preferred 44 to 56 solar panel elements.

The advantage of this roof tile is that by providing two or more solar elements the harvesting of direct and indirect sunrays is improved. It will also provide for an effective way of achieving a profiled roof tile with the ability to harvest direct and indirect sunrays from different directions.

The roof tile roof tile may comprise a plurality of rows of solar panel elements being arranged along the x-direction of the roof tile, wherein the solar panel elements in each row may be electrically connected in parallel and wherein the plurality of rows of solar panel elements may be electrically connected in series.

The advantage of electrically connecting the solar panel elements in each row of solar panel elements in parallel is that if one solar panel element, is not performing or even is out of service, the roof tile will still be able to produce electricity. Thus, by electrically connecting the solar panel elements in each row of solar panel elements in parallel and the plurality of rows in series, the largest possible output power of the roof tile will be obtained.

Alternatively, the roof tile may comprise a plurality of columns of solar panel elements being arranged along the y-direction of the roof tile, wherein the solar panel elements in each column may be electrically connected in series and wherein the plurality of columns of solar panel elements may be electrically connected in parallel.

This provides an alternative way of electrically connecting the solar panel elements. By connecting the solar panel elements in each column in series and connecting the plurality of columns in parallel, the largest possible output power of each roof tile will not be obtained. However, this way of connecting the solar panel elements works, and produces a decent amount of output power.

A connection box for output of electricity from the solar panel elements may be positioned at one end of the roof tile, such that no hole in the base element of the roof tile is needed for wiring to the solar panel elements. Preferably the connection box may comprises a bypass diode coupled to overcome negative effects from shading, damages or other malfunction of the roof tile.

This position of the connection box is very advantageous in that the roof tile will resist moisture better and give the complete roof a better resistance to varying weather conditions over time. In particular, when snow is compressed during winter and forming ice, this will be highly advantageous.

The base element and the top element as attached together may provide the necessary strength to function as a roof tile, but the base element and the top element individually may not have the strength for use as a roof tile themselves.

It is advantageous that the assembly of a weaker base element and a weaker top element will provide the necessary mechanical properties for the assembly to function as a roof tile. The base element may be lighter than a comparable conventional roof tile. The assembly may even be lighter than a comparable roof tile with for example a heavier base element that in itself provide the necessary mechanical properties.

Each individual solar panel element may be flat.

The advantage of comprising flat solar panel elements is that they are easy to manufacture and give a high output yield per surface area.

It is also proposed a roof comprising the roof tile as presented above.

The disclosure further proposes a method for producing a roof tile. The method comprises the steps of: providing a base element comprising concrete or clay, providing a top element, wherein the top element is arranged to fit with the base element. The method further comprises providing solar panel elements in between the top element and the base element, under the top element or providing the solar panel elements comprised within the top element. The method further comprises attaching the top element to the base element, wherein both the base element and the top element are arranged such that the roof tile provides a profiled shape section.

The advantage of the method is that the roof tile is effectively produced and that high quality with low rejected products is achieved.

The step of attaching the top element to the base element may comprise attaching the top element to the base element by glue, rivets, screws, bolts, and/or by insertion of the top element into recesses formed in the base element or vice versa.

The advantage is a simple and maintenance friendly roof tile is achieved.

When the base element comprises concrete, the method may further comprise a step of hardening the concrete base element with the top element and the solar panels attached, thus providing a complete roof tile with inbuilt solar panel.

It is particularly advantageous to harden the base element to the top element. A very swift way of producing the roof tile as well as a mechanically well-functioning roof tile is achieved. In addition, this will provide the possibility to avoid further fastening elements, thus the design of the roof tile is simplified.

The step of providing a base element may comprise providing the base element by extruding or molding of the base element.

Extruding the base element is as mentioned with the roof tile, an advantageous method of producing a roof tile with good mechanical properties.

The disclosure further proposes a machine for producing a roof tile.

The machine will be able to produce the roof tile exploring the presented method and thus giving a good production rate with high quality.

### BRIEF DESCRIPTION OF THE DRAWINGS

Fig. 1 schematically illustrates a perspective view of a roof tile.
Fig. 2 schematically illustrates an example of a cross-sectional view of a section of a roof tile.
Fig. 3 schematically illustrates a side view of a roof tile.
Fig. 4 schematically illustrates reception of direct and indirect sunrays at different angles within a roof tile.
Figs. 5a and 5b schematically illustrate examples of roof tiles comprising electrically connected solar panel elements.
Fig. 6 schematically illustrates a roof comprising a plurality of interlocked roof tiles.
Fig. 7 schematically illustrates a plurality of electrically connected roof tiles.
Fig. 8 schematically illustrates a method for producing a roof tile.

### DETAILED DESCRIPTION

The present disclosure relates to a roof tile. The roof tile comprises a base element and a transparent top element. The roof tile further comprises a group of solar panel elements.

The roof tile has the same function as a conventional roof tile in terms of protecting a building from weather conditions, such as rain, hail, snow and wind while at the same time being capable of converting solar energy impinging on the roof tiles into electricity. In addition, the roof tile may be arranged to provide the same aesthetic appearance as a conventional roof tile in terms of shape and color. It also provides for flexibility since the roof tiles may be effectively arranged on a roof comprising angles, corners, windows and chimneys onto which large solar panel arrangement(s) is not appropriate.

A roof tile may comprise a profiled shaped section, such that the form of a circle segment, and a flat section. Alternatively, the roof tile may comprise only a profiled portion. The roof tile may comprise a plurality of profiled shaped sections and thus a plurality of circle segments. The radii of the circle segments of the plurality of circle segments of the roof tile may be the same or different. The profiled shape of the roof tile may be irregular it may not need to be a circle segment per se, it may any irregular shape, for example oval or several circle segments following each other with different radiuses etc. Other profiled shapes are also possible, such as a plurality of alternately profiled shaped sections or a plurality of alternately profiled shape sections and flat sections.

In general, a roof tile is an element that can be handled by one person and be positioned on a roof. Thus, it shall have means for attaching it to the roof and it shall not be too heavy or large in order to be positioned on the roof. It is not to be understood as to be possible to cover an entire roof, a half of the roof, or a quarter of a roof with only one roof-tile. A roof typically comprises 5 to 15 roof tiles per square meter. In one example, the size of the roof tile is 420x330 mm. Preferably, the roof tile is not larger than 400x500 mm. A pattern of roof tiles in general shall be understood to cover a roof. It shall also be understood that the roof tile is the outermost portion of a roof of a building.

For this disclosure a roof tile is defined to have a vertical direction named y-direction, and a horizontal direction named x-direction. Vertical direction means that the direction that will include both a low point and a high point when the roof tile is mounted on a roof. Vertical direction should not be confused to mean that the roof-tile is to stand on one side and point upwards at 90 degrees in use. X-direction essentially is referring to the horizontal direction of a mounted roof tile. This will not include the high point and the low point on a line drawn parallel with this direction.

For this disclosure, a roof is defined to have an essentially vertical direction named y-direction, and a horizontal direction named x-direction. The y-direction is thus the same as a line following the shortest way from the lowest side of the roof to the highest side i.e. the roof ridge, as in disclosed in the drawings.

A solar panel, or photovoltaic module, is used for converting solar energy into electricity. A plurality of solar panels may be mounted onto a roof of a building or may form a solar power plant on ground. The electricity may be used for operation of electrical equipment in the building onto which the solar panel is positioned or it may be provided to the public electricity grid.

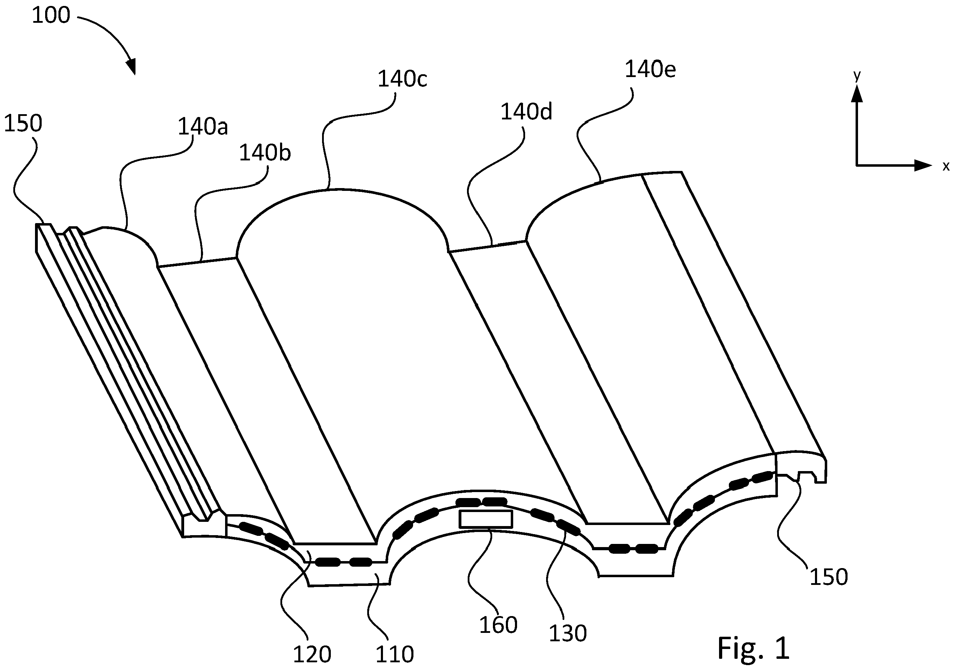

Fig. 1 schematically illustrates a perspective view of a roof tile according to the present disclosure.

The roof tile 100 comprises a base element 110 and a transparent top element 120. The roof tile further comprises a group of solar panel elements 130.

The roof tile 100 further comprises a profiled shaped section 140a-140e. The roof tile 100 may comprise more than one profiled shaped section, such as two, three, four, five or six profiled shaped sections. By profiled shaped section is meant that the shape section has a curvature. The profiled section is in general the section of the roof tile that will not be aligned with a transversal direction on a roof which the tile to be used. This means that if a roof tile is positioned on a flat surface the whole section will protrude from this flat surface with an angle.

The base element 110 is arranged for providing a support for the solar panel elements 130 and/or for the transparent top element 120. The base element 110 typically comprises similar profiled shaped section(s) 140a-140e as the roof tile 100. The base element 110 may, but need not, have the same strength as a conventional roof tile. Typically, the base element 110 does not have the necessary strength for use as a roof tile itself.

The thickness of the base element 110 may be uniform over the entire base element, alternatively the thickness may vary in the x- or y-direction of the roof tile.

The base element 110 comprises concrete or clay. Preferably, the base element 110 comprises extruded concrete or clay. By concrete is meant a mixture comprising sand, cement and water. Typically, the sand of the concrete has a particle size of up to 4 mm. Thus, the thickness of the base element 110 at its thinnest portion(s) may preferably not be thinner than 5 to 6 mm. By clay is meant a fine-grained natural soil material comprising minerals.

By extruded concrete or clay is meant that the concrete or clay is pushed through a die, tooling or nozzle of a desired cross-section, thereby converting the concrete or clay into the desired shape, such as the desired shape of the base element. Alternatively, the base element 110 may be provided by molding. Molding may take place under an elevated temperature and/or pressure.

The base element 110 may further be provided with one or more holes for wiring the solar panel elements together. However, typically no hole in the base element of the roof tile is needed for wiring the solar panel elements 130.

The base element 110 is arranged to fit with the top element 120. Preferably, the transparent top element 120 and the base element 110 have a similar profiled shape. By similar profiled shape is meant that the transparent top element 120 and the base element 110 have a shape such that they are arranged to fit with each other. Thus, the transparent top element 120 and the base element 110 typically comprises the similar profiled shaped section(s) 140a-140e as the roof tile 100.

The base element 110 may further be coloured through with for example oxides and/or be provided with coatings in order to provide a desired aesthetic appearance.

The transparent top element 120 is arranged for protecting the solar panel elements 130 from weather conditions as well as from wear upon people walking on the roof etc. The top element 120 is transparent in order to allow for reception of direct and indirect sunrays by the solar panel elements. By transparent is meant that it allows for at least 50 %, preferably at least 80 % of the light of the sunrays to pass through.

The transparent top 120 element may be arranged to cover at least the solar panel elements 130. In addition, the transparent top element 120 may, but need not, be arranged to cover the entire base element 110. In one example, the transparent top element covers the entire base element 110 except from an at least one interlocking section 150 of the base element 110.

The top element 120 may comprise glass or resin, such as plastics. If the transparent top element comprises glass, the glass preferably comprises tempered glass. By tempered glass is meant that the glass has been exposed to thermal or chemical treatment in order to increase its strength as compared to non-tempered glass. Examples of suitable plastics materials are durable and resistant plastic materials, such as acrylic materials.

The transparent top element 120 is arranged to fit with the base element 110. Preferably, the base element 110 and the top element 120 have the similar profiled shape.

The thickness of the transparent top element 120 may be uniform, alternatively the thickness of the top element may vary in the x- or y-direction of the roof tile. In one example, the thickness of the top element 120 at the thinnest portion(s) of the top element may be about 1 to 4 mm.

The roof tile further comprises a group of solar panel elements 130. By solar panel elements is meant a photovoltaic element capable of converting light from sunrays into electricity. The solar panel elements are comprised between the top element 120 and the base element 110, under or within the top element 120. By "between" is meant that the solar panel element is positioned between the top element 120 and the base element 110. By "under" is meant that the solar panel element is attached to the portion of transparent top element being arranged to be attached to the base element. By "within" is meant that the solar panel element is integrated within the transparent top element, for example by molding or laminating. The solar panel elements may, but need not be provided in a recess of the base element 110, and/or in a recess of the top element 120.

In yet an example, the roof tile comprises at least one intermediate element 170a, 170b. The intermediate element may be a sandwiched between the top element 120 and the base element 110. The intermediate element 170a, 170b may be arranged on top of and/or below the solar panel elements 130. The intermediate element 170a, 170b may cover the complete surface of the base element and/or the top element. Alternatively, the intermediate element may cover a portion of the base element 110 and/or top element 120. In one an example, the solar panel elements are laminated between two intermediate elements 170a, 170b. Alternatively, the solar panel elements are laminated between the top element 120 and the at least one intermediate element 170a, 170b. If the intermediate element is arranged on top of the solar panel elements, the intermediate element is transparent. If the intermediate element is arranged below the solar panel elements, it may be transparent, but it may also have any other colour such as black or white. The solar panel elements 130 may, but need not, be attached to the top element 120 and/or to the base element 110 and/or intermediate layer by adhesive means, such as glue. The solar panel elements may have any suitable length and width, in one example, the width of each solar panel element is about 20 mm.

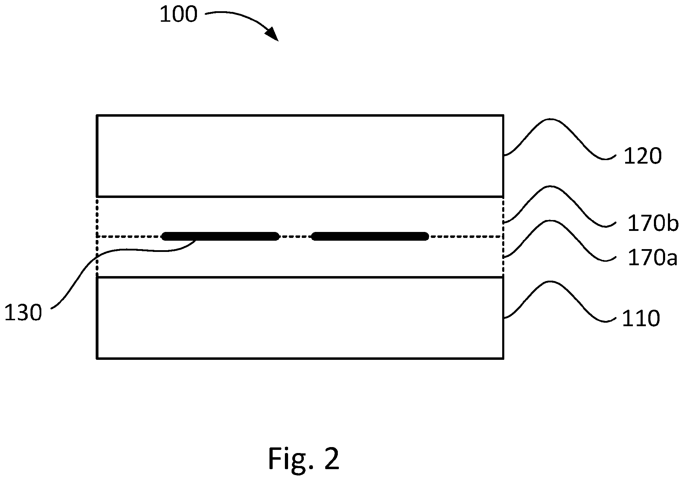

Fig. 2 shows an example of a cross-sectional view of the roof tile.

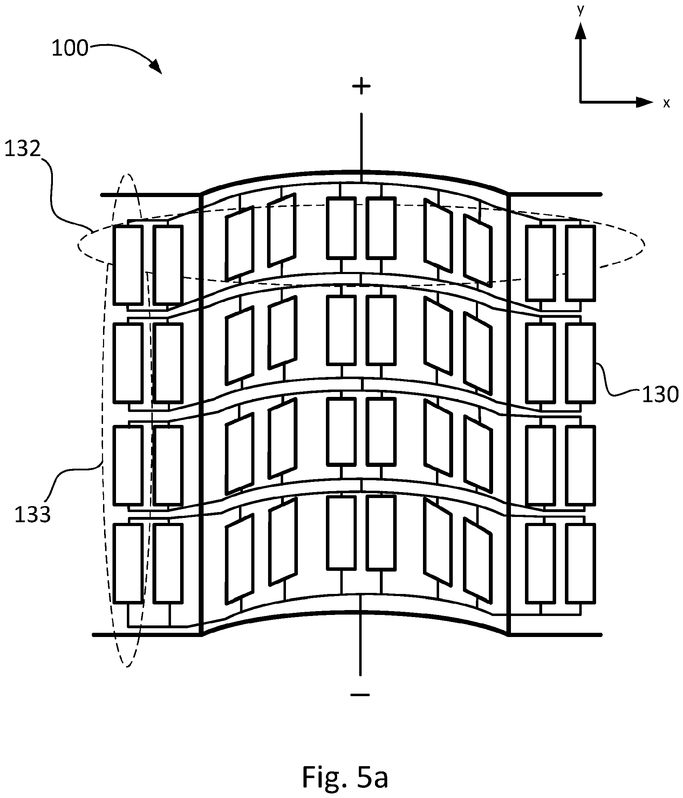

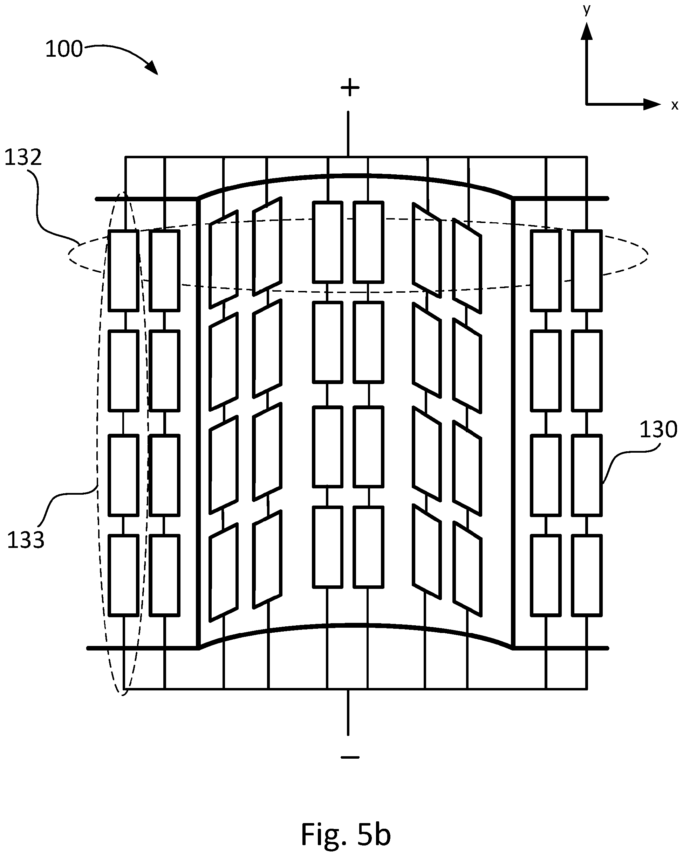

The solar panel elements 130 may, but need not, be evenly arranged within the roof tile. The number of solar panel element may be chosen depending on the size and design of the roof tile, such as the size and number of profiled shaped sections. Typically, the roof tile comprises about 10-100, or as an example 40-60, or preferably 44 to 56, solar panel elements 130. The solar panel elements may be arranged such that they do not cover the complete base element of the roof tile 100. For example, no solar cell elements 130 may be arranged at an at least one interlocking section 150 where two roof tiles may be interlocked to each other. Examples of arrangements of the solar panel elements are shown in Figs 5a and 5b.

In one example the solar panel elements comprises silicon. Alternatively, the solar panel elements may comprise nitrides or thin film solar cells, such as copper indium gallium selenide solar cells (CIGS) or dye-sensitized solar cells. In a further example, the solar panel elements may comprise organic-based molecules or polymers. Each individual solar panel element 130 may be flat.

The roof tile 100 further comprises at least one interlocking section 150. The interlocking section 150 is arranged for interlocking adjacent roof tiles 100 together upon roofing/installation of a roof. The interlocking section 150 may be provided along the entire or a portion of at least one end of the roof tile 100. The interlocking section 150 may be arranged such that it is possible to interlock a roof tile of the present disclosure with a conventional roof tile not comprising solar panel elements. The interlocking section 150 may comprise the same material as the base element 110 and/or the top element 120. In one example, the interlocking section 150 may comprise concrete or clay, preferably extruded concrete or clay.

The roof tile further comprises a connection box 160 for output of electricity from the solar panel elements being positioned at one end of the roof tiles. In one example, the connection box may be arranged in a recess (not shown) of the roof tile. The recess may be arranged in the base element, top element or in both the base element and top element of the roof tile. Each roof tile may comprise a connection box. Alternatively, a row or column of roof tiles of interlocked roof tiles on a roof may comprise a common connection box (not shown) for output of electricity from the solar panel elements. The connection box of each roof tile is connected to the connection box of the adjacent roof tiles along the x- and/or y-direction of the roof. The output power from connection boxes of each roof tile may thereby be led into the building.

The base element 110 and top element 120 may be attached to each other by glue, rivets, screws, bolts, and/or by insertion of the top element into recesses formed in the base element or vice versa. In one example, the glue may be a so-called slurry, comprising concrete. In yet an alternative, which will be discussed more in detail below, when the base element 110 comprises concrete, the concrete base element, top element 120 and the solar panel elements 130 may be attached to each other by hardening thereby providing a complete roof tile with inbuilt solar panels. The latter alternative may be combined with attaching the base element 110 and the top element 120 by e.g. glue, such as slurry.

The base element and the top element as attached together, provides the necessary strength to function as a roof tile, but the base element and the top element individually typically does not have the strength for use as a roof tile themselves. By necessary strength to function as a roof tile is meant that the roof tile should be strong enough to walk on, for example upon inspection of the roof and upon snow shoveling. The roof tile should also be able to withstand tough weather conditions, such as rain, hail, wind and heavy snow.

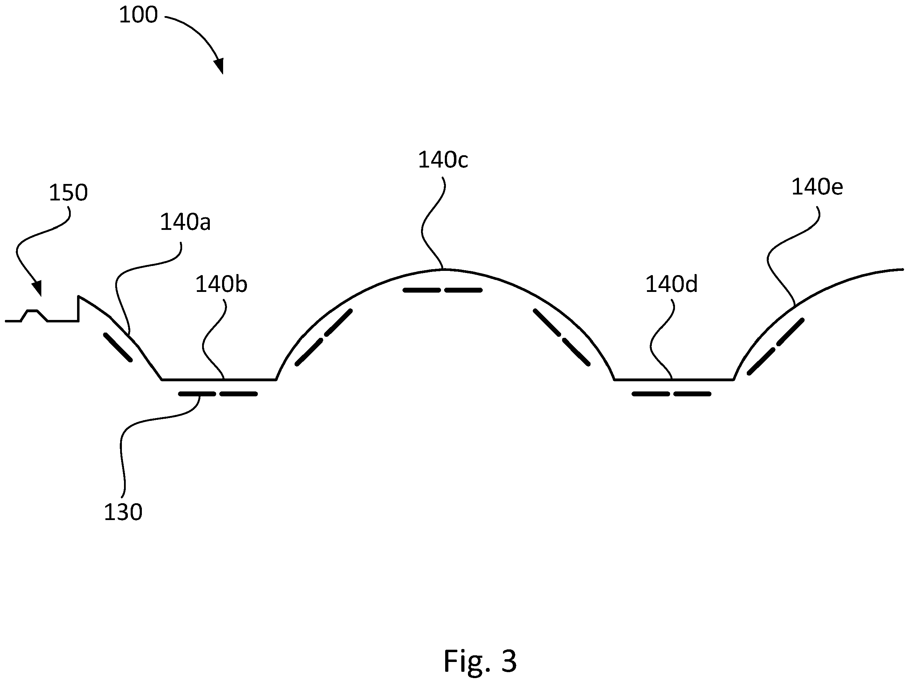

Fig. 3 shows a side view of a roof tile according to the present disclosure.

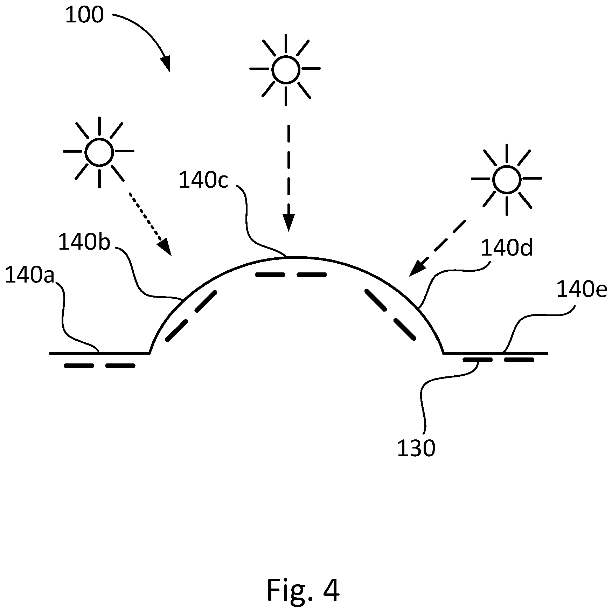

Fig. 4 schematically illustrates reception of sunrays at different angles within a roof tile.

As shown in Figs. 5a and 5b, the solar panel elements arranged along the x-direction of a roof tile form rows 132 of solar panel elements 130 and the solar panel elements 130 arranged along the y-direction of a roof tile form columns 133.

The roof tile comprises a profiled shape section 140a-140e. Each profiled shape section 140a-140e may comprise at least a column 133 of the solar panel elements 130. Each column 133 may comprise at least one solar panel element 130. Preferably, the column 133 comprises about four solar panel elements 130. A profiled shape section 140a-140e of a roof tile 100 may comprise the same or a different number of solar panel elements 130 as compared to an adjacent profiled shape section of the roof tile. Preferably, the solar panels elements 130 are arranged such that there is at least one column of solar panel elements in each profiled shape section 140a-140e. The solar panel elements 130 within one column 133 may, but need not be evenly spaced along the y-direction of the profiled shape section of the roof tile 100. The solar panel elements 130 may be arranged above and/or beside one another along the x- and y-direction of the roof tile.

As shown in Fig. 4, the solar panel elements 130 being arranged in the profiled shaped sections 140a-140e are arranged at different angles within the roof tile such that they allow for different angles of reception of direct and indirect sunrays within the roof tile. By direct sunrays is meant sunrays from the sun not being reflected before impinging on the roof tile. By indirect sunrays is meant sunrays being reflected, e.g. on adjacent roof tiles or surroundings, before impinging on the roof tile.

Figs. 5a and 5b schematically illustrate examples of roof tiles comprising electrically connected solar panel elements.

In one example, as shown in Fig. 5a, the roof tile comprises a plurality of rows 132 of solar panel elements 130 being arranged along the x-direction of the roof tile 100, wherein the solar panel elements in each row are electrically connected in parallel and wherein the plurality of rows of solar panel elements are electrically connected in series. The solar panel elements 130 within one row 132 may, but need not be evenly spaced along the x-direction of the profiled shape section of the roof tile 100.

As shown in Figs. 5a and 5b, the serial connection may preferably be along the y-direction of the roof tile. This will prevent a deficient element from setting the level of output power from the group of solar panel elements being in the same plane and having the same angle to the sun at any moment.

As discussed with respect to Fig. 4 above, the solar panel elements 130 may typically be arranged such that there is at least one column 133 of solar panel elements 130 in each profiled section. As mentioned above, the profiled shape section allows for different angles of reception of direct and indirect sunrays within the roof tile. This means that a column 133 of solar panel elements thereby may provide a different output power with respect to an adjacent column 133 of solar panel elements. Since the solar panel element 130 producing the lowest amount of current, when connected in series, limits the total output current, it is advantageously to connect the individual solar panel elements 130 in parallel and the rows 132 of solar panel elements 130 in series, as shown in Fig. 5a. In one example this way of connecting the solar panel elements provides for an output power from each roof tile of about 2 V and 5-15 A, preferably about 10 A. The output power depends on the reception of direct and indirect light from the sunrays, the type of material in the solar panel elements 130 and the size and number of solar panel elements 130.

In another example, as shown in Fig. 5b, the roof tile comprises a plurality of columns 133 of solar panel elements 130 being arranged along the y-direction of the roof tile, wherein the solar panel elements in each column are connected in series and wherein the plurality of columns 133 are connected in parallel. Similar to the electrical connection shown in Fig. 5a, the serial connection may preferably be along the y-direction of the roof tile. This is an alternative which is fully functional, however, typically the output power becomes slightly lower as compared to the example shown in Fig. 5a.

All roof tiles of the roof, or groups of roof tiles, are preferably connected in series into wiring(s), which are connected to an inverter or equivalent. Such grouping of roof tiles into separate wirings connected to an inverter or equivalent can be used to separate parts of a roof having different solar environment, such as inclination or compass direction, or to separate a larger number of roof tiles into more manageable groups in terms of system level voltages and currents. Preferably individual roof tiles make use of bypass diodes to overcome negative effects from shading, damages or other malfunction of individual roof tiles. Alternatively, adjacent roof tiles are connected in series along the horizontal direction of the roof forming a row, wherein the rows of roof tiles are electrically connected either in parallel or directly as wirings to an inverter or equivalent. In yet an alternative, the adjacent roof tiles along the horizontal direction of the roof are connected in parallel forming a row, wherein the rows of roof tiles are electrically connected either in series or directly as wirings to an inverter or equivalent.

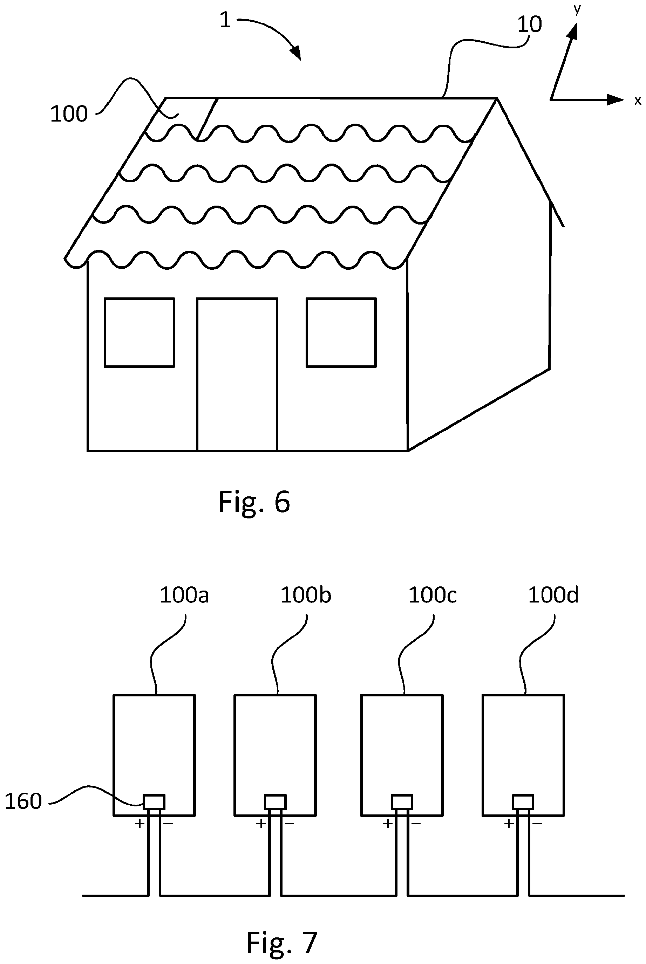

Fig. 6 schematically illustrates a building with a roof comprising a plurality of interlocked roof tiles.

Each roof tile 100 may be interlocked with an adjacent roof tile thus providing a roof 10 on a building 1.

Fig. 7 schematically illustrates a plurality of electrically connected roof tiles.

In one example, the roof tiles according to the present disclosure may be combined with conventional roof tiles, thereby forming a roof. Combination with conventional roof tiles is especially suitable at areas of the roof where the size or shape of the roof tile has to be cut in order to be adapted to the shape and dimension of the roof of the building, such as near a chimney and/or near the edges of the roof. In a further example, a portion of a roof comprises the roof tiles according to the present disclosure, whereas the other portions of the roof is comprised of conventional roof tiles and/or accessories, such as chimneys or windows.

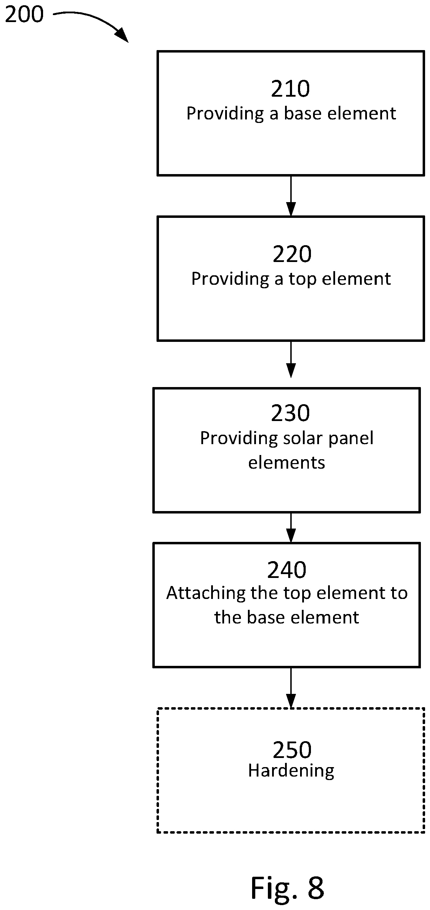

Fig. 8 schematically illustrates a method of producing a roof tile.

The method 200 comprises the step of providing a base element comprising concrete or clay 210.

The method further comprises providing a top element 220. The top element is arranged to fit with the base element. The top element may be provided by molding into a desired profile. The method further comprises a step of providing solar panels 230 in between the top element and the base element, under the top element or providing the solar panels comprised within the top element. The method further comprises a step of attaching the top element to the base element 240, wherein both the base element and the top element are arranged such that the roof tile provides a profiled shape section. The top element may be attached to the base element by glue, rivets, screws, bolts, and/or by insertion of the top element into recesses formed in the base element or vice versa. In the latter example, the recesses may be formed upon the step of providing the base element and/or the step of providing the top element.

In one example, wherein the base element comprises concrete, the method may further comprise a step of hardening 250 the concrete base element with the top element and the solar panels attached, thus providing a complete roof tile with inbuilt solar panel. The hardening may be performed at a temperature of about 20 to 60 °C in a humid environment. The step of hardening with the top element and the solar panels attached is not possible for roof tiles comprising a base element of clay, which has to be burned at a temperature of about 800 to 900 °C. The burning has to be performed at the step of providing the base element 210, i.e. prior to the step of attaching the base element and top element together 240 in order to not harm or destroy the glass, solar panel elements or wirings of the solar panel elements.

The disclosure is further related to a machine for producing a roof tile according the method above.

The machine in general provides an extruder die, nozzle or tooling and a compartment for pressurizing the material to be extruded. The machine further provides for the extruded base element to be joined with the top element including the solar panel element. It should be understood that the machine may have two separate production positions, one for extruding the base element, and one for assembling the base element with the top element. Also further stations may be applicable for example a station where the connection box is attached to the roof tile.

## Claims

1. Roof tile (100) wherein the roof tile comprises a base element (110) and further is comprised a transparent top element (120),
wherein the roof tile (100) comprises a group of solar panel elements (130),
wherein the solar panel elements (130) are comprised between the top element (120) and the base element (110), under or within the top element,
wherein the roof tile (100) comprises a profiled shape section (140a, 140b, 140c, 140d, 140e) which comprises solar panel elements (130),
wherein the profiled shape section allows for different angles of reception of direct and indirect sunrays within the roof tile (100),
**characterized in that**
the base element (110) comprises concrete or clay.

2. The roof tile (100) according to claim 1, wherein the group of solar panel elements (130) comprises silicon, and/or wherein the top element (120) comprises glass or resin, preferably the top element comprises tempered glass, and/or wherein the base element (110) comprises extruded concrete or clay.

3. The roof tile (100) according to any of the preceding claims, further comprising at least one intermediate element (170a, 170b) between the top element (120) and the base element (110).

4. The roof tile (100) according to any of the preceding claims, comprising at least one interlocking section (150), wherein the interlocking section comprises concrete or clay, preferably extruded concrete or clay.

5. The roof tile (100) according to any of the preceding claims, wherein the group of solar panel elements (130) comprises at least two solar panel elements, preferably the group of solar panel elements comprises 10-100, preferably 40-60 or even more preferred 44 to 56 solar panel elements.

6. The roof tile (100) according to any of the preceding claims, wherein the roof tile comprises a plurality of rows (132) of solar panel elements (130) being arranged along the x-direction of the roof tile, wherein the solar panel elements in each row are electrically connected in parallel and wherein the plurality of rows of solar panel elements are electrically connected in series, or wherein the roof tile comprises a plurality of columns (133) of solar panel elements (130) being arranged along the y-direction of the roof tile, wherein the solar panel elements in each column are electrically connected in series and wherein the plurality of columns of solar panel elements are electrically connected in parallel.

7. The roof tile (100) according to any of the preceding claims, wherein a connection box (160) for output of electricity from the solar panel elements (130) is positioned at one end of the roof tile, such that no hole in the base element of the roof tile is needed for wiring to the solar panel elements, preferably the connection box (160) comprises a bypass diode coupled to overcome negative effects from shading, damages or other malfunction of the roof tile.

8. The roof tile (100) according to any of the preceding claims, wherein the base element (110) and the top element (120) as attached together, provides the necessary strength to function as a roof tile, but the base element and the top element individually does not have the strength for use as a roof tile themselves.

9. The roof tile (100) according to any of the preceding claims, wherein each individual solar panel element (130) is flat.

10. Roof (10) comprising a plurality of interlocked roof tiles (100) according to any of claims 1 to 9.

11. Method (200) for producing a roof tile, comprising the steps of:
providing a base element (210) comprising concrete or clay,
providing a top element (220), wherein the top element is arranged to fit with the base element,
providing solar panel elements (230) in between the top element and the base element, under the top element or providing the solar panel elements comprised within the top element, and
attaching the top element to the base element (240), wherein both the base element and the top element are arranged such that the roof tile provides a profiled shape section.

12. The method (200) for producing a roof tile according to claim 11, wherein the step of attaching the top element to the base element comprises attaching the top element to the base element by glue, rivets, screws, bolts, and/or by insertion of the top element into recesses formed in the base element or vice versa.

13. The method (200) according to claim 11 or 12, wherein the base element comprises concrete, further comprising a step of hardening (250) the concrete base element with the top element and the solar panels attached, thus providing a complete roof tile with inbuilt solar panel.

14. The method (200) for producing a roof tile according to claim 11, wherein the step of providing a base element (210) comprises providing the base element by extruding or molding of the base element.

15. Machine for producing a roof tile according the method of any of claims 11 to 14.
